Europäisches Patentamt

European Patent Office

Office européen des brevets

(19)

(11) Numéro de publication : **0 616 287 A1**

# (12) DEMANDE DE BREVET EUROPEEN

(21) Numéro de dépôt : **94400566.9**

(22) Date de dépôt : **15.03.94**

(51) Int. Cl.$^5$ : **G06F 13/40, H03K 3/356**

(30) Priorité : **19.03.93 FR 9303209**

(43) Date de publication de la demande :
**21.09.94 Bulletin 94/38**

(84) Etats contractants désignés :
**AT BE DE DK ES FR GB IT NL SE**

(71) Demandeur : **ALCATEL RADIOTELEPHONE**
**10, rue de la Baume**
**F-75008 Paris (FR)**

(72) Inventeur : **Vianney, Andrieu**
**129, Avenue Parmentier**
**F-75011 Paris (FR)**

(74) Mandataire : **Renaud-Goud, Thierry et al**
**c/o SOSPI,**
**14-16, rue de la Baume**
**F-75008 Paris (FR)**

(54) **Procédé de contrôle de la polarité d'un signal numérique et circuits intégrés mettant en oeuvre ce procédé.**

(57)    Procédé de contrôle de la polarité d'un signal numérique (S) issu d'un premier circuit intégré (A), ce signal numérique (S) étant représentatif d'une information (I) générée au sein de ce circuit intégré et devant être appliqué sur une entrée d'un second circuit intégré (B) requérant une polarité prédéterminée.

Le procédé comprend une mémorisation (MP) de la polarité requise, effectuée à l'extérieur dudit premier circuit intégré (A) au niveau de la sortie du signal numérique, une séquence d'acquisition (AC) de ladite polarité requise mémorisée pendant laquelle l'information (I) est inactive, et une séquence d'application (AP) de ladite polarité requise à l'information (I) active pour générer sur une sortie dudit premier circuit intégré le signal numérique (S) à appliquer en entrée dudit second circuit intégré (B).

Utilisation dans des systèmes numériques incluant des circuits intégrés provenant de sources multiples.

FIG_1

EP 0 616 287 A1

La présente invention concerne un procédé de contrôle de la polarité d'un signal numérique issu d'un circuit intégré.

Elle vise également des circuits intégrés mettant en oeuvre ce procédé.

Les concepteurs de systèmes numériques sont souvent amenés à prévoir des sources multiples d'approvisionnement pour des composants essentiels tels que des microprocesseurs, des microcontrôleurs ou encore des mémoires, afin de pouvoir s'adapter aux meilleures conditions économiques ou technologiques du moment. Or, il arrive fréquemment que des composants de source différente mais assurant les mêmes fonctions présentent des entrées de commande, par exemple d'interruption, de polarité différente.

On entend par polarité une fonction arbitraire qui fait correspondre à une valeur binaire un niveau électrique. par exemple, dans le cas de circuits alimentés entre 0 et 5 volts, une polarité positive fera correspondre à une valeur binaire 0, un niveau de tension nul et à une valeur binaire 1, un niveau de tension égal à 5 volts; une polarité négative fera correspondre à une valeur binaire 0, un niveau de tension égal à 5 volts et à une valeur binaire 1, un niveau de tension nul.

Un problème se pose lorsqu'il s'agit de connecter un premier circuit intégré chargé d'émettre une information sur une broche de sortie, notamment un signal de commande tel qu'une demande d'interruption, à un second circuit intégré qui peut provenir de sources différentes et requérir une polarité positive ou bien négative sur la broche d'entrée prévue pour recevoir cette information. Il n'est alors pas concevable de prévoir une connexion des circuits sans contrôle de polarité.

Une première solution consiste à prévoir en entrée du premier circuit "émetteur" un signal indicatif de la polarité requise par le second circuit "récepteur", qui est combiné à l'information à transmettre pour générer le signal de sortie. Mais cette solution présente l'inconvénient de nécessiter une broche supplémentaire sur le boîtier du circuit concerné, ce qui est difficilement concevable pour des circuits insérés dans des boîtiers normalisés. A fortiori, il peut arriver que plusieurs signaux issus du premier circuit "émetteur" nécessitent un contrôle de polarité séparé. La mise en oeuvre de cette solution implique alors de prévoir plusieurs broches supplémentaires.

Une seconde solution consiste à programmer un signal indicatif de la polarité requise à l'intérieur du premier circuit après acquisition de ce signal par un organe de contrôle de polarité via un bus externe. Cette seconde solution présente l'inconvénient de nécessiter un organe de contrôle, externe ou interne au premier circuit. De plus, si le signal de sortie influe sur le fonctionnement de l'organe de contrôle, comme c'est par exemple le cas si le signal de sortie est un signal d'interruption, une telle solution logicielle s'avère particulièrement délicate à mettre en oeuvre. En outre, le problème de la détermination de la polarité n'est pas éliminé mais reporté au niveau de l'organe de contrôle.

On connait par ailleurs le brevet US 4 940 904 qui décrit un circuit de sortie pour produire des impulsions positives ou négatives. Ce circuit relativement complexe fait appel à un signal d'horloge. Il est ainsi conçu que l'impulsion de sortie est retardée par rapport à l'impulsion d'entrée et que la forme de cette impulsion de sortie dépend directement de la forme du signal d'horloge. La solution retenue consiste à produire successivement les deux formes possibles du signal de sortie de sorte que l'une ou l'autre d'entre elles soit prise en compte par le circuit récepteur selon qu'il présente une polarité positive ou négative. Il n'y a pas réellement de contrôle de la polarité du signal de sortie.

Le but de la présente invention est de remédier à ces inconvénients en proposant un procédé de contrôle de polarité qui ne nécessite pas l'adjonction d'une broche supplémentaire au circuit intégré.

Suivant l'invention, le procédé de contrôle de la polarité d'un signal numérique issu d'un premier circuit intégré, ce signal numérique étant représentatif d'une information générée au sein de ce circuit intégré et devant être appliqué sur une entrée d'un second circuit intégré requérant une polarité prédéterminée, est caractérisé en ce qu'il comprend:

- une mémorisation de la polarité requise, effectuée à l'extérieur dudit premier circuit intégré au niveau de la sortie du signal numérique ;
- une séquence d'acquisition de ladite polarité requise mémorisée, pendant laquelle l'information est inactive ; et
- une séquence d'application de ladite polarité requise à l'information active pour générer sur une sortie dudit premier circuit intégré le signal numérique à appliquer en entrée dudit second circuit intégré, lesdites séquences d'acquisition et d'application de polarité étant effectuées au sein dudit premier circuit intégré.

Ainsi, le procédé selon l'invention permet de résoudre le problème du contrôle de polarité sans nécessiter d'organe de contrôle extérieur, grâce à une simple mémorisation de la polarité à l'extérieur du premier circuit. Les séquences d'acquisition et d'application sont internes au circuit et ne vont donc pas nécessiter l'ajout d'une broche supplémentaire au boîtier du circuit.

Suivant un autre aspect de l'invention, il est proposé un circuit intégré émettant un signal numérique de sortie représentatif d'une information générée par des moyens logiques internes et devant être appliqué sur une entrée d'un second circuit intégré requérant une polarité prédéterminée, mettant en oeuvre le procédé selon l'invention et caractérisé en ce que des moyens de mémorisation de la polarité requise sont prévus à l'extérieur dudit circuit intégré selon l'invention, et en ce qu'il comprend en outre des moyens pour acquérir ladite polarité requise et des moyens pour appliquer ladite polarité acquise à l'information en vue de générer le signal numérique de sortie, ces moyens d'application recevant des moyens d'acquisition un signal de polarité indicatif de la polarité requise.

D'autres particularités et avantages de l'invention apparaîtront encore dans la description ci-après. Aux dessins annexés donnés à titre d'exemples non limitatifs:

- la figure 1 est un schéma synoptique illustrant le principe général du procédé selon l'invention;
- la figure 2A représente la structure interne d'un circuit intégré mettant en oeuvre le procédé selon l'invention et connecté à une entrée de circuit demandant une polarité négative ;
- la figure 2B représente le circuit intégré de la figure 2A connecté à une entrée de circuit demandant une polarité positive ;
- la figure 3A est un chronogramme des signaux principaux activés dans le procédé selon l'invention, dans le cas de la configuration de la figure 2A; et
- la figure 3B est un chronogramme des signaux principaux activés dans le procédé selon l'invention, dans le cas de la configuration de la figure 2B.

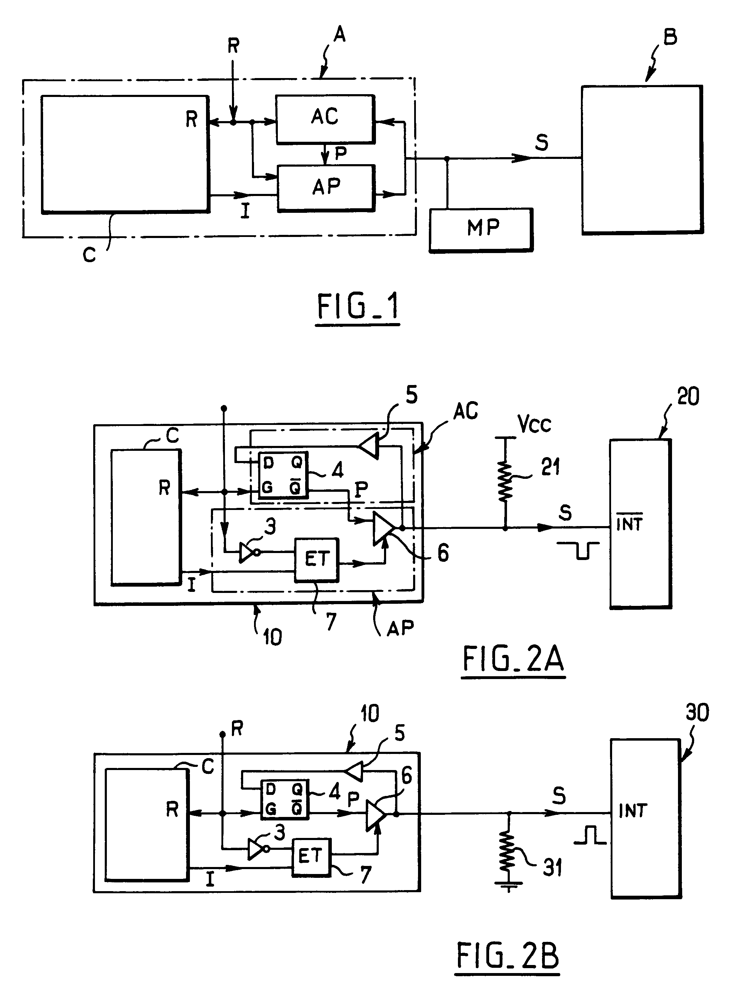

On va maintenant décrire une forme particulière de mise en oeuvre du procédé selon l'invention en même temps qu'un exemple de circuit mettant en oeuvre le procédé selon l'invention, en référence aux figures 1, 2A et 2B.

On considère un premier circuit intégré A conçu pour mettre en oeuvre le procédé selon l'invention de façon à ce que sa sortie S puisse être connectée sans problème avec une entrée d'un second circuit intégré B, pouvant présenter aussi bien une polarité positive que négative.

Le circuit intégré A selon l'invention comprend, outre une partie fonctionnelle C délivrant une information I destinée à être transmise au circuit récepteur B, un module AC d'acquisition de polarité et un module d'application de polarité AP, et est muni, sur sa ligne de sortie, d'un module de mémorisation de polarité MP. Le module d'acquisition de polarité AC, interne au circuit A, reçoit comme entrées le signal de sortie S et un signal de remise à zéro R appliqué également au module fonctionnel C, et génère un signal de polarité P traité par le module d'application de polarité AP qui reçoit également en entrée le signal de remise à zéro R et l'information I émise par le module fonctionnel C. Le module d'application de polarité AP génère le signal de sortie S.

Le procédé de contrôle de polarité selon l'invention comporte une phase d'acquisition de polarité au cours de laquelle le module fonctionnel C est inactif au sens où l'information I est à un niveau dit inactif, par exemple un niveau logique 0. Au cours de cette phase d'acquisition, la sortie S est placée en état de haute impédance et le module de mémorisation MP maintient cette sortie à niveau de tension prédéterminé correspondant à un niveau logique considéré comme inactif. Si ce niveau logique est 1 (tension de sortie égale par exemple à 5 Volts), on est en situation de polarité négative; dans le cas contraire, pour un niveau logique 0 (tension de sortie sensiblement nulle), on est en situation de polarité positive. L'activation du signal de remise à zéro R provoque la mise en oeuvre du module d'acquisition AC qui vient "lire" le niveau de haute impédance du signal de sortie S et génère un signal de polarité P. La fin de l'activation du signal de remise à zéro R conclut la phase d'acquisition et le module d'application de polarité AP peut alors générer un signal de sortie actif en réponse à une entrée d'information I active.

Un circuit intégré ainsi agencé peut alors s'adapter à toute polarité, comme l'illustrent les deux configurations de polarités respectivement négative et positive représentées en figures 2A et 2B.

Dans le premier cas, où un circuit intégré 10 est connecté à une entrée de polarité négative d'un circuit 20, par exemple un microprocesseur ou un microcontrôleur, en référence à la figure 2A, le module de mémorisation de polarité consiste en une résistance 21 de tirage de la sortie à la tension d'alimentation Vcc, la sortie S étant reliée par exemple à une entrée d'interruption INT (polarité négative) du microprocesseur 20.

Dans le second cas, où le même circuit intégré 10 est connecté à une entrée de polarité positive d'un autre microprocesseur 30, le module de mémorisation de polarité consiste en une résistance 31 de tirage de la sortie à la masse, la sortie S étant reliée une entrée d'interruption INT (polarité positive) du microprocesseur 30.

Dans ces exemples, le circuit 10 selon l'invention comprend, au titre du module d'acquisition, une bascule 4 de type D recevant sur son entrée D le signal de sortie à travers un amplificateur ou "buffer" non inverseur 5, sur son entrée de déclenchement G le signal de remise à zéro R, et délivrant sur sa sortie inversée $\overline{Q}$ le signal de polarité P.

Le circuit 10 comprend également, au titre du module d'application de polarité, une porte logique ET 7 recevant comme entrées, d'une part, l'inverse logique du signal de remise à zéro R à travers un inverseur logique 3 et d'autre part, l'information I émise par le module fonctionnel C, et un amplificateur de type "trois états" ou "haute impédance" 6 recevant en entrée le signal de polarité P, commandé par la sortie de la porte logique ET 7 et générant le signal de sortie S.

L'amplificateur 6 est placé en haute impédance lorsque sa commande, en l'occurrence le signal de sortie de la porte logique ET 7, est au niveau logique 0.

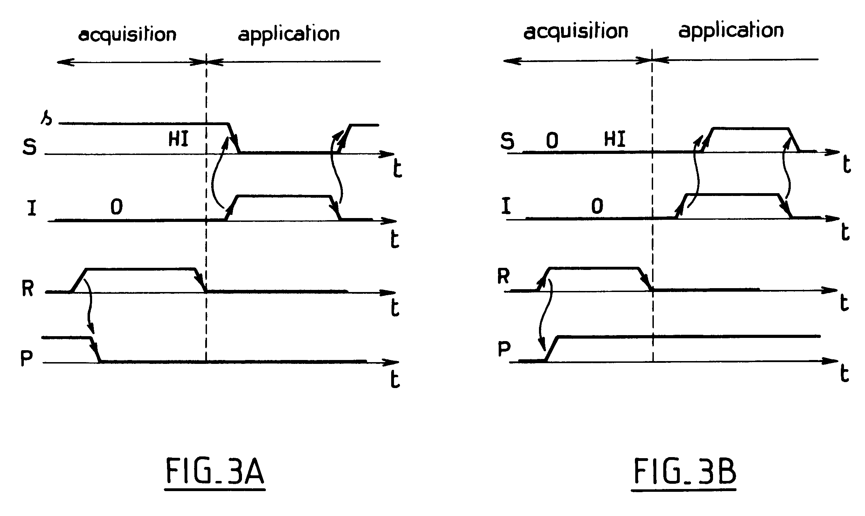

On va maintenant décrire en détail l'évolution temporelle des signaux de sortie S, et de polarité P, en fonction de l'état du signal de remise à zéro R et de l'information I, dans les deux configurations précitées, en référence aux figures 3A et 3B.

Dans le premier cas correspondant à une polarité négative illustré en figure 3A, au début de la phase d'acquisition, la sortie S est en état de haute impédance au niveau logique 1 puisque l'amplificateur trois-états 6 n'est pas commandé, l'information I est au niveau logique 0 (état inactif), et le signal de remise à zéro R est activé, passant du niveau logique 0 au niveau logique 1. L'entrée G de la bascule 4 est de fait activée et la sortie $\overline{Q}$ de ladite bascule 4 mémorise l'inverse du niveau logique présent en entrée à l'instant du front montant sur l'entrée de commande G, à savoir l'inverse du niveau logique de la sortie S. Le signal de polarité P est donc placé au niveau logique 0 indicatif d'une polarité négative. Le front descendant du signal de remise à zéro R marque la fin de la phase d'acquisition et le début de la phase d'application. Au moment où l'information I commute dans un état actif (niveau logique 1), la porte ET 7 génère un signal de sortie de niveau logique 1 qui active l'amplificateur trois-états 6, provoquant le forçage de la sortie S au niveau logique du signal de polarité P, à savoir 0. On observe ainsi que l'information I a été transmise sous la forme d'une impulsion S en polarité négative.

Dans le cas d'un circuit récepteur en polarité positive, en référence aux figures 2B et 3B, en phase d'acquisition, l'état de repos en haute impédance de la sortie S est le niveau logique 0 correspondant à une tension sensiblement nulle du fait de la résistance 31 de tirage à la masse. Lorsque le signal de remise à zéro R est activé, la bascule 4 mémorise l'état de l'entrée D, à savoir le niveau logique 0 de la sortie S, et le signal de polarité P est alors forcé au niveau logique 1. En phase d'application, lorsque l'information I devient active, la porte ET 7 émet en sortie un niveau logique 1 qui provoque l'activation de l'amplificateur trois-états 6. Ce dernier émet en sortie S l'image du signal de polarité P, à savoir un niveau logique 1. Lorsque l'information I repasse au niveau logique 0, le signal de sortie S suit puisque l'amplificateur trois-états 6 reste activé. On observe donc que le signal de sortie S reproduit sensiblement l'impulsion d'information I, dans un contexte de polarité positive.

Bien sûr, l'invention n'est pas limitée aux exemples qui viennent d'être décrits et de nombreux aménagements peuvent être apportés à ces exemples sans sortir du cadre de l'invention.

Ainsi, les modules d'acquisition, d'application et de mémorisation peuvent être conçus de bien d'autres façons que celle qui vient d'être décrite, en utilisant notamment d'autres types de portes logiques.

En outre, le procédé selon l'invention peut être appliqué au contrôle de polarité de nombreux types de signaux impliqués dans un système numérique, notamment des signaux d'acquittement (ACK), d'interruption (INT) ou tous autres signaux de commande ou de contrôle.

## Revendications

1. Procédé de contrôle de la polarité d'un signal numérique (S) issu d'un premier circuit intégré (A, 10), ce signal numérique (S) étant représentatif d'une information (I) générée au sein de ce circuit intégré et devant être appliqué sur une entrée d'un second circuit intégré (B) requérant une polarité prédéterminée, caractérisé en ce qu'il comprend:
   - une mémorisation (MP) de la polarité requise, effectuée à l'extérieur dudit premier circuit intégré (A, 10) au niveau de la sortie du signal numérique ;
   - une séquence d'acquisition (AC) de ladite polarité requise mémorisée pendant laquelle l'information (I) est inactive ; et
   - une séquence d'application (AP) de ladite polarité requise à l'information (I) active pour générer sur une sortie dudit premier circuit intégré le signal numérique (S) à appliquer en entrée dudit second circuit intégré (B), lesdites séquences d'acquisition (AC) et d'application (AP) de polarité étant effectuées au sein dudit premier circuit intégré (A).

2. Procédé selon la revendication 1, caractérisé en ce que la séquence d'acquisition (AC) est associée à une étape de remise à zéro du premier circuit intégré (A).

3. Procédé selon l'une des revendications 1 ou 2, caractérisé en ce que la sortie du premier circuit intégré (A) est placée, lorsque l'information (I) est inactive ou pendant la séquence d'acquisition (AC), en état de haute impédance et forcée, de manière externe audit premier circuit (A) à un niveau logique représentatif d'un état inactif selon la polarité requise.

4. Circuit intégré (10) émettant un signal numérique de sortie (S) représentatif d'une information (I) générée par des moyens logiques internes (C) et devant être appliqué sur une entrée d'un second circuit intégré (B) requérant une polarité prédéterminée, mettant en oeuvre le procédé selon l'une quelconque des revendications 1 à 3, caractérisé en ce que des moyens (21, 31) de mémorisation de la polarité requise sont prévus à l'extérieur dudit circuit intégré (10) selon l'invention, et ce qu'il comprend en outre des moyens (AC) pour acquérir ladite polarité requise et des moyens (AP) pour appliquer ladite polarité acquise à l'information (I) en vue de générer le signal numérique de sortie (S), ces moyens d'application (AP) recevant des moyens d'acquisition (AC) un signal de polarité (P) indicatif de la polarité requise.

5. Circuit (10) selon la revendication 4, caractérisé en ce que les moyens d'application (AP) comprennent des moyens (6) pour placer en état de haute impédance la sortie (S) dudit circuit (10) lorsque les moyens d'acquisition (AC) sont activés, et en ce que les moyens de mémorisation (MP) sont agencés pour que, dans cet état de haute impédance, la sortie (S) soit maintenue à un niveau logique représentatif d'un état inactif selon la polarité requise.

6. Circuit (10) selon la revendication 5, caractérisé en ce que les moyens de mémorisation (MP) consistent en une résistance de tirage (21, 31) reliant la sortie (S) soit à une ligne d'alimentation (Vcc) dans le cas d'une polarité requise négative, soit à une ligne de masse dans le cas d'une polarité requise positive.

7. Circuit (10) selon l'une des revendications 5 ou 6, caractérisé en ce que les moyens d'acquisition (AC) comprennent des moyens de bascule D (4) recevant en entrée (D) un signal image du signal de sortie (S), en entrée de commande (G) un signal de remise à zéro (R) des moyens. logiques internes (C), et générant le signal de polarité (P) fourni aux moyens d'application (AP).

8. Circuit (10) selon l'une quelconque des revendications 5 à 7, caractérisé en ce que les moyens d'application (AP) comprennent des moyens d'amplification trois-états (6) recevant en entrée le signal de polarité (P), générant le signal de sortie (S), et commandés en basse impédance par un signal de commande activé au cours de la séquence d'application.

9. Circuit (10) selon la revendication 8, caractérisé en ce que les moyens d'application (AP) comprennent en outre des moyens de commande (7, 3) pour combiner un signal de remise à zéro (R) et l'information (I) en vue de générer le signal de commande en basse impédance.

10. Circuit (10) selon la revendication 9, caractérisé en ce que les moyens de commande (7, 3) comprennent une porte logique ET (7) recevant en entrées l'information (I) et l'inverse logique du signal de remise à zéro (R).

FIG_1

FIG.2A

FIG_2B

FIG.3A

FIG.3B

EP 0 616 287 A1

Office européen
des brevets

**RAPPORT DE RECHERCHE EUROPEENNE**

Numero de la demande
EP 94 40 0566

## DOCUMENTS CONSIDERES COMME PERTINENTS

| Catégorie | Citation du document avec indication, en cas de besoin, des parties pertinentes | Revendication concernée | CLASSEMENT DE LA DEMANDE (Int.Cl.5) |
|---|---|---|---|
| X<br>A | US-A-4 940 904 (LIN)<br>* colonne 2, ligne 43 - colonne 3, ligne 7 *<br>* colonne 5, ligne 55 - colonne 7, ligne 46 *<br>* colonne 10, ligne 1 - ligne 61 *<br>* abrégé; figures 1,3-8 *<br>--- | 1-8<br>9,10 | G06F13/40<br>H03K3/356 |
| A | US-A-4 504 745 (SPENCE ET AL.)<br>* colonne 1, ligne 42 - colonne 2, ligne 2 *<br>* colonne 4, ligne 10 - ligne 43 *<br>* abrégé; figures 1,2 *<br>--- | 1-8 | |
| A | US-A-5 189 319 (FUNG ET AL.)<br>* colonne 1, ligne 18 - ligne 38 *<br>* colonne 2, ligne 23 - colonne 4, ligne 4 *<br>* abrégé; figures 1,2 *<br>----- | 1-8 | |
| | | | **DOMAINES TECHNIQUES RECHERCHES (Int.Cl.5)**<br><br>G06F<br>H03K |

Le présent rapport a été établi pour toutes les revendications

| Lieu de la recherche | Date d'achèvement de la recherche | Examinateur |
|---|---|---|
| LA HAYE | 28 Juin 1994 | Nguyen Xuan Hiep, C |